# EUROPÄISCHE PATENTSCHRIFT

(11) **EP 3 405 981 B1**
(45) Veröffentlichungstag und Bekanntmachung des Hinweises auf die Patenterteilung: **04.11.2020**
(21) Anmeldenummer: 17706764.2
(22) Anmeldetag: 22.02.2017
(51) Int. Cl.: H01L 31/167, H01L 31/0203, H01L 31/0232, H01L 25/16

(54) **MODULAR AUFGEBAUTE OPTOELEKTRONISCHE VORRICHTUNG**
MODULAR DESIGNED OPTOELECTRONIC DEVICE
DISPOSITIF OPTOÉLECTRONIQUE MODULAIRE

(30) Priorität: 23.02.2016 DE 102016103123
(43) Veröffentlichungstag der Anmeldung: 28.11.2018
(73) Patentinhaber: Vishay Semiconductor GmbH, 74072 Heilbronn (DE)
(72) Erfinder: BURGER, Daniel, 74211 Leingarten (DE); KUHN, Sascha, 74229 Oedheim (DE); MÜHLECK, Peter, 74254 Offenau (DE)
(74) Vertreter: Manitz Finsterwald Patent- und Rechtsanwaltspartnerschaft mbB
(86) Internationale Anmeldenummer: PCT/EP2017/054069
(87) Internationale Veröffentlichungsnummer: WO 2017/144535

(56) Entgegenhaltungen:
- EP-A2- 1 371 010
- DE-A1- 10 241 934
- JP-A- 2015 162 473
- US-A1- 2010 200 735

## Beschreibung

Die vorliegende Erfindung betrifft eine optoelektronische Vorrichtung mit einer Trägereinrichtung, die an einer Oberseite wenigstens einen optoelektronischen Sender und wenigstens einen optoelektronischen Empfänger aufweist. Die Trägereinrichtung kann zugleich zur elektrischen Kontaktierung des optoelektronischen Senders und des optoelektronischen Empfängers dienen. Oberhalb der Trägereinrichtung, d.h. bezüglich einer Vertikalrichtung oberhalb des Senders und Empfängers, ist wenigstens ein optisches Element zur optischen Beeinflussung einer dem Sender und/oder Empfänger zugeordneten Strahlung angeordnet.

Derartige optoelektronische Vorrichtungen sind insbesondere als optoelektronische Sensorvorrichtungen ausgebildet, um Eigenschaften von Objekten optisch abtasten und elektronisch erfassen zu können. Ein Anwendungsfall für solche Sensorvorrichtungen liegt im Bereich von kommerziell erhältlichen Druckergeräten, d.h. Vorrichtungen zum computergestützten Bedrucken von Papier mittels bekannter Drucktechnologien, z.B. der Laserdruck- oder Tintenstrahldrucktechnologie. Um einen möglichst vollautomatischen und benutzerfreundlichen Betrieb eines Druckers (oder eines einen Drucker umfassenden Multifunktionsgeräts) zu ermöglichen, müssen verschiedene Betriebsparameter des Druckers, wie etwa eine Menge oder ein Typ des in ein Aufnahmefach des Druckers eingelegten Papiers, ein vorgesehenes Papierformat, die relative Position einer Papierkante und dergleichen ermittelt und gegebenenfalls überwacht werden. Ferner besteht Bedarf an einer automatischen Analyse eines jeweiligen Druckergebnisses oder eines zu scannenden Papiers, um z.B. den Inhaltstyp (Bild vs. Text) des zu scannenden Papiers oder die korrekte Konfigurierung (z.B. mechanische Ausrichtung einer Druckeinheit des Druckers) anhand eines Druckergebnisses zu überprüfen.

Typischerweise ist für jeden zu messenden Betriebsparameter eine individuell angepasste optoelektronische Vorrichtung vorgesehen, welche dazu ausgebildet ist, ein emittiertes optisches Signal mit einem detektierten, z.B. reflektierten optischen Signal zu vergleichen, um aus der Differenz dieser optischen Signale den betreffenden Betriebsparameter bestimmen können. Bei den optischen Signalen handelt es sich im Allgemeinen um elektromagnetische Strahlung einer sichtbaren oder unsichtbaren Wellenlänge, insbesondere Infrarot. Häufig umfasst die Vorrichtung sowohl einen optoelektronischen Sender als auch (wenigstens) einen optoelektronischen Empfänger. So kann die Vorrichtung beispielsweise als Näherungssensor fungieren. Ferner sind Vorrichtungen mit mehreren Sendern und Empfängern möglich, wobei eine Vorrichtung z.B. mehrere Betriebsparameter insbesondere zeitgleich bestimmen kann (z.B. mit einer Unterscheidung zwischen diffuser und spiegelnder Reflexion).

Aufgrund der Vielzahl zu messender Betriebsparameter ist eine entsprechende Vielfalt von optoelektronischen Vorrichtungen erforderlich, was mit einem unerwünschten Kostenaufwand in der Herstellung und Lagerhaltung verbunden ist. Ferner muss eine optotelektronische Vorrichtung zur Messung eines jeweiligen Betriebsparameters spezifische optische Eigenschaften erfüllen, welche in Abhängigkeit von dem betreffenden Betriebsparameter sehr unterschiedlich sein können und diesbezüglich einen hohen Entwicklungsaufwand erfordern. Als optische Eigenschaften sind insbesondere die Führung, Formung oder Filterung von Strahlen bzw. optischen Signalen zu verstehen, welche zur Messung des jeweiligen Betriebsparameters von dem optoelektronischen Sender ausgesendet und/oder von dem optoelektronischen Empfänger empfangen werden. Hierbei kann auch eine geometrische Begrenzung der Strahlenbündel erforderlich sein, wobei insbesondere eine Querschnittsausdehnung und/oder ein Winkelbereich der Strahlen festgelegt wird.

DE 102 41 934 A1 offenbart ein optisches Sensorsystem mit einem Gehäuse, das einen Austrittslichtweg und einen Eintrittslichtweg definiert, wobei mehrere Licht emittierende Elemente vorgesehen sind, die den Lichtaustrittsweg gemeinsam zur Beleuchtung von Druckmedien innerhalb eines Kopiergeräts benutzen, wobei ferner ein Sensor vorgesehen ist, der von dem beleuchteten Objekt reflektiertes Licht über den Eintrittslichtweg empfängt.

US 2010/200735 A1 offenbart einen optischen Sensor zum Erfassen einer Bewegung in einem interessierenden Bereich. Der optische Sensor umfasst eine Basis mit optischen Filtereigenschaften. Eine Sensoranordnung mit einer Leuchtdiode, einem CMOS-Sensor und einem Linsenpaar ist an der Basis montiert. Der CMOS-Sensor hat einen Bereich von Lichtwellenlängen, für den er eine erhöhte Empfindlichkeit hat. Die optischen Filtereigenschaften der Basis sind so angeordnet, dass sie Lichtwellenlängen im Bereich erhöhter Empfindlichkeit des CMOS-Sensors absorbieren. Auf diese Weise werden die Auswirkungen von Umgebungslicht auf den optischen Sensor reduziert.

DE 102 41 934 A1 offenbart nicht, dass eine Trägereinrichtung zwischen einem Unterteil und einem Oberteil einer Halteeinrichtung gefangen ist. Ferner werden das Oberteil sowie optische Elemente nicht an der Trägereinrichtung fixiert.

Es ist eine Aufgabe der Erfindung, eine Vorrichtung der eingangs genannten Art bereitzustellen, deren optische Eigenschaften auf einfache Art und Weise sowie präzise festgelegt werden können.

Die Aufgabe wird gelöst durch eine optoelektronische Vorrichtung mit den Merkmalen des Anspruchs 1.

Eine optoelektronische Vorrichtung umfasst wenigstens ein erstes optisches Element, ein zweites optisches Element und ein drittes optisches Element, die in einer Schichtanordnung oberhalb der Trägereinrichtung angeordnet sind, wobei das zweite optische Element oberhalb des ersten optischen Elements angeordnet ist und das dritte optische Element oberhalb des zweiten optischen Elements angeordnet ist, und wobei jedes der wenigstens drei optischen Elemente ein Linsenelement, ein Aperturelement oder ein Filterelement umfasst. Ferner ist eine Halteeinrichtung vorgesehen, die wenigstens das erste optische Element und das zweite optische Element relativ zu der Trägereinrichtung hält und teilweise umgibt, wobei die Halteeinrichtung ferner das dritte optische Element bildet.

Durch die wenigstens drei optischen Elemente werden die relevanten optischen Eigenschaften der Vorrichtung bezüglich des optoelektronischen Senders oder Empfängers festgelegt. Hierbei können eines oder mehrere der drei optischen Elemente gemeinsam einen optischen Kanal für den Sender oder Empfänger bilden. Ein solcher optischer Kanal bildet also einen optischen Einfallspfad bzw. Emissionspfad der optoelektronischen Vorrichtung, wobei der optische Kanal eine imaginäre Achse besitzt, die vorzugsweise durch den optoelektronischen Sender oder Empfänger verläuft und das geometrische und/oder optische Zentrum eines sich abschnittsweise durch die optoelektronische Vorrichtung hindurch erstreckenden strahlungsdurchlässigen Bereichs der optoelektronischen Vorrichtung definiert. Die Achse des optischen Kanals kann z.B. senkrecht oder geneigt zu einer Erstreckungsebene der Trägereinrichtung verlaufen. Vorzugsweise ist für jeden an der optoelektronischen Vorrichtung angeordneten optoelektronischen Sender und Empfänger ein separater zugeordneter optischer Kanal vorgesehen.

Ein Vorteil der Erfindung besteht darin, dass wenigstens drei separate optische Elemente vorgesehen sind. Hierdurch können die optischen Eigenschaften des optischen Kanals auf einfache Weise und dennoch mit hoher Genauigkeit festgelegt werden.

Die optoelektronische Vorrichtung zeichnet sich durch einen modularen Aufbau aus, bei dem die Vorrichtung nach Art eines Baukastensystems aus verschiedenen separaten Komponenten zusammengesetzt ist. Diese separaten Komponenten umfassen zumindest die Trägereinrichtung, das erste optische Element, das zweite optische Element und die Halteeinrichtung, wobei das dritte optische Element ebenfalls separat ausgebildet oder in die Halteeinrichtung integriert sein kann. Die einzelnen Komponenten werden vorzugsweise lösbar miteinander verbunden oder aneinandergehalten. Insbesondere können die Komponenten kraftschlüssig und/oder formschlüssig aneinander gehalten sein. Die Komponenten sind entlang der genannten Vertikalrichtung im Wesentlichen hintereinander, d.h. in einer Schichtanordnung bzw. Sandwich-Struktur angeordnet. Hierdurch können verschiedene Varianten der Trägereinrichtung, der optischen Elemente sowie optionale Komponenten auf einfache Weise auf Basis einer universellen Modulplattform miteinander kombiniert werden, um unterschiedliche optoelektronische Vorrichtungen herzustellen, wobei einige Komponenten der unterschiedlichen optoelektronischen Vorrichtungen gleichartig sein können (z.B. die Halteeinrichtung).

Die optoelektronische Vorrichtung kann zumindest im Wesentlichen quaderförmig sein, wobei zumindest einige der genannten separaten Komponenten einen länglichen, im Wesentlichen rechteckigen Umriss aufweisen können.

Die Trägereinrichtung der optoelektronischen Vorrichtung kann zumindest im Wesentlichen plattenförmig sein und/oder einen umspritzten Leiterrahmen umfassen. Die Trägereinrichtung kann mehrere elektrische Anschlüsse umfassen, welche mit einem ASIC (Application-Specific Integrated Circuit) der Trägereinrichtung und/oder mit dem optoelektronischen Sender oder Empfänger verbunden sein können. Die Anschlüsse der Trägereinrichtung können eine elektrische Kontaktierung von außen ermöglichen. Die Anschlüsse können insbesondere zur Anbindung der Trägereinrichtung an einen der optoelektronischen Vorrichtung zugeordneten Microcontroller vorgesehen sein, um die Vorrichtung anwendungsgemäß betreiben zu können. Die eingangs genannte Vertikalrichtung kann insbesondere senkrecht zu einer Erstreckungsebene der Trägereinrichtung verlaufen.

Die Halteeinrichtung dient dazu, zumindest die Trägereinrichtung, das erste und das zweite optische Element relativ zueinander zu halten, wobei eine Ausrichtung der beiden optischen Elemente bezüglich der Trägereinrichtung eingehalten wird, die mit dem wenigstens einen optoelektronischen Sender und wenigstens einem optoelektronischen Empfänger bestückt ist. Hierbei kann die Halteeinrichtung das erste optische Element und/oder das zweite optische Element direkt oder indirekt an der Trägereinrichtung sichern und/oder fixieren. Die Halteeinrichtung kann hierfür beispielsweise eine Klammer oder wenigstens ein klammerartiges Element aufweisen, welches zumindest die Trägereinrichtung, das erste und das zweite optische Element umgreift oder hintergreift. Zusätzlich oder alternativ kann die Halteeinrichtung gehäuseartig oder käfigartig ausgebildet sein, wobei eine solche Halteeinrichtung die Trägereinrichtung, das erste optische Element und das zweite optische Element nicht vollständig umschließen muss, insbesondere nicht vollflächig und auch nicht an jeder Seite der Vorrichtung. Die Halteeinrichtung kann somit zumindest funktional als Gehäuse der Vorrichtung dienen oder sogar ein echtes, zumindest überwiegend geschlossenes Gehäuse sein, wobei zumindest eine mechanische Kapselung der Komponenten der Vorrichtung sichergestellt wird. Es versteht sich, dass auch weitere Komponenten durch die Halteeinrichtung gehalten oder fixiert sein können.

Die Halteeinrichtung kann insbesondere eine Basisplatte mit mehreren Seitenwänden und/oder mit mehreren, insbesondere zwei, vier oder sechs paarweise einander gegenüberliegenden, Haltearmen oder Halteabschnitten aufweisen. Die Basisplatte kann eine einheitliche Plattengröße besitzen, die z.B. an die Form und Größe der Trägereinrichtung und/oder eines der optischen Elemente angepasst ist. Hierdurch kann die Vorrichtung robust und kompakt ausgebildet werden, wobei ein Anhaften oder Eindringen von Schmutz und dergleichen an bzw. in die Vorrichtung vermieden wird. Vorzugsweise ist die Basisplatte an einer Unterseite der Trägereinrichtung angeordnet und bildet einen Bodenabschnitt. Die Halteeinrichtung kann einen zumindest abschnittsweise stufenförmigen und/oder U-förmigen Querschnitt und/oder mehrere Öffnungen aufweisen, sodass eine in die Halteeinrichtung eingelegte Komponente der Vorrichtung, welche zumindest abschnittsweise komplementär zu der Halteeinrichtung ausgebildet ist, in der Halteeinrichtung seitlich und/oder in Vertikalrichtung gefangen ist, ohne dass es hierfür gesonderter Befestigungsmittel bedarf. Beispielsweise können die Trägereinrichtung, das erste optische Element und das zweite optische Element in Vertikalrichtung gefangen sein, d.h. die jeweilige Komponente ist zwischen der Halteeinrichtung und einer anderen Komponente der Vorrichtung oder zwischen zwei anderen Komponenten der Vorrichtung durch gegenseitigen Kontakt in Vertikalrichtung festgelegt. Die Halteeinrichtung ist zweiteilig ausgebildet.

Die optischen Elemente können zumindest im Wesentlichen plattenförmig sein, wobei die Plattengröße und/oder die Plattenform einer einheitlichen Plattengröße und/oder Plattenform zumindest einiger der Komponenten der Vorrichtung entsprechen kann.

Im Zusammenhang mit der Erfindung ist unter einem Linsenelement ein Abbildungselement zu verstehen, das insbesondere refraktive (d.h. lichtbrechende) Eigenschaften aufweisen kann. Das Linsenelement kann insbesondere einen Linsenabschnitt für den wenigstens einen optoelektronischen Sender und/oder einen Linsenabschnitt für den wenigstens einen optoelektronischen Empfänger aufweisen.

Der jeweilige Linsenabschnitt kann strahlformende Eigenschaften aufweisen, insbesondere indem der jeweilige Linsenabschnitt an einer Seite oder an zwei Seiten eine Wölbung aufweist (z.B. als Sammellinse, Zerstreuungslinse oder Fresnel-Linse). Alternativ oder zusätzlich hierzu kann der jeweilige Linsenabschnitt eine Umlenkung eines Strahlbündels bewirken, d.h. eine Änderung der Ausbreitungsrichtung eines emittierten oder empfangenen Strahlbündels. Insbesondere kann der jeweilige Linsenabschnitt eine Keilform aufweisen (z.B. Ausgestaltung als Keillinse mit zwei in einem spitzen Winkel zueinander ausgerichteten Planflächen). Der jeweilige Linsenabschnitt kann parallel oder schräg zu einer Erstreckungsebene der Trägereinrichtung ausgerichtet sein. Das Linsenelement kann außerhalb des jeweiligen Linsenabschnitts plattenförmig sein. Der jeweilige Linsenabschnitt kann integral ausgebildet und/oder oberhalb des optoelektronischen Senders bzw. Empfängers angeordnet sein.

Sofern eines der optischen Elemente ein Aperturelement umfasst, so kann dieses einen Einfallswinkelbereich für optische Strahlen definieren, welche auf den wenigstens einen optoelektronischen Empfänger eintreffen. Alternativ oder zusätzlich definiert das Aperturelement einen Emissionswinkelbereich für optische Strahlen, welche von dem wenigstens einen optoelektronischen Sender durch den optischen Kanal emittiert werden. Der jeweilige Winkelbereich kann insbesondere durch eine Ausrichtung und einen Öffnungswinkel definiert sein, wodurch ein optischer Kanal zumindest abschnittsweise festgelegt wird.

Das Aperturelement kann insbesondere einen Aperturabschnitt für den wenigstens einen optoelektronischen Sender und/oder einen Aperturabschnitt für den wenigstens einen optoelektronischen Empfänger aufweisen. Ein jeweiliger Aperturabschnitt kann durch eine Öffnung des betreffenden Aperturelements gebildet sein, die beispielsweise kreisrund oder oval ist und bezüglich der Achse des gebildeten optischen Kanals koaxial ausgerichtet oder versetzt ist. Durch die Anordnung und Formgebung des jeweiligen Aperturabschnitts können geometrische optische Eigenschaften der optoelektronischen Vorrichtung festgelegt und unerwünschte Störeinflüsse (z.B. aufgrund interner oder äußerer Reflexionen) unterdrückt werden. Hierfür können vorteilhaft mehrere separate, mit einem jeweiligen Aperturelement ausgestattete Aperturelemente vorgesehen werden, wobei jedes der Aperturelemente eine Begrenzung des Querschnitts des von dem zugeordneten Sender emittierten und/oder von dem zugeordneten Empfänger empfangenen Strahlenbündels bewirken kann. Beispielsweise können zwei ein jeweiliges Aperturelement bildende optische Elemente in unterschiedlichem Abstand von der Trägereinrichung angeordnet werden, insbesondere auf unterschiedlichen Seiten eines Linsenelements. Somit kann jedes der Aperturelemente einen Beitrag zu den erwünschten optischen Eigenschaften des optischen Kanals liefern, wobei sich die durch jedes Aperturelement realisierten optischen Eigenschaften zusammen überlagern oder in funktionaler Weise kombinieren (z.B. Begrenzung des Einfallswinkelbereichs bzw. Emissionswinkelbereichs und Funktion als Streulichtblende). Mit anderen Worten können die Maßnahmen der geometrischen Begrenzung der Strahlenbündel zur Realisierung der gewünschten optischen Eigenschaften der optoelektronischen Vorrichtung auf zwei oder mehrere Aperturelemente verteilt werden. Die mechanische Komplexität der jeweiligen Aperturelemente kann hierdurch im Vergleich zu dem Fall eines einzigen Aperturelements geringer gehalten werden, was einerseits den Entwurf, andererseits aber auch die industrielle Herstellung der Aperturelemente vereinfacht.

Zur Definition des genannten Einfalls- und/oder Emissionswinkelbereichs kann der jeweilige Aperturabschnitt des Aperturelements einen sich in Richtung zu der Trägereinrichtung verjüngenden Querschnitt aufweisen. Der betreffende Aperturabschnitt kann insbesondere durch eine zumindest im Wesentlichen kegelstumpfförmige Öffnung gebildet sein, welche insbesondere bei geneigter Achse des optischen Kanals geschert sein kann.

Zumindest eines der optischen Elemente der optoelektronischen Vorrichtung kann ein Filterelement umfassen, welches spektrale Filtereigenschaften besitzt. Insbesondere kann das Filterelement einen planparallelen Filterabschnitt aufweisen, welcher spektrale Filtereigenschaften besitzt.

Es versteht sich, dass ein jeweiliges optisches Element nicht ausschließlich entweder ein Linsenelement, ein Aperturelement oder ein Filterelement umfassen muss. Es sind auch Kombinationen von Linsenelement, Aperturelement und Filterelement möglich. Beispielsweise kann ein Linsenelement mit integrierten spektralen Filtereigenschaften vorgesehen werden. Hiervon unberührt ist aber die Tatsache, dass stets wenigstens drei optische Elemente vorgesehen sind, von denen jedes zumindest eine der genannten Funktionen (Refraktion, Apertur, Filterung) erfüllt.

Der modulare Aufbau der Vorrichtung ist in der Kombination mit den wenigstens drei optischen Elementen besonders vorteilhaft, um eine Vielzahl unterschiedlicher Vorrichtungstypen mit im Wesentlichen einheitlichen, nur geringfügig unterschiedlichen Komponenten kostengünstig herstellen zu können. Hierbei können die für einen jeweiligen Vorrichtungstyp erforderlichen optischen Eigenschaften beispielsweise festgelegt werden, indem die Form und/oder die Position wenigstens eines Aperturabschnitts eines Aperturelements eines der optischen Elemente, die Form und/oder Position eines Linsenabschnitts eines Linsenelements, und/oder die Form und/oder Position eines Filterabschnitts eines Filterelements angepasst werden. Hierfür können unterschiedliche auswählbare Aperturelemente und/oder unterschiedliche auswählbare Linsenelemente und/oder unterschiedliche auswählbare Filterelemente vorgesehen sein. Der Grundaufbau der optoelektronischen Vorrichtung, insbesondere die äußere Form der einzelnen Komponenten, braucht hierbei nicht verändert zu werden.

Nachfolgend werden einige beispielhafte Konfigurationen der Schichtanordnung der drei optischen Elemente erläutert.

Gemäß einer Ausführungsform umfasst das erste optische Element ein erstes Aperturelement, das zweite optische Element ein Linsenelement, und das dritte optische Element ein weiteres Aperturelement. Mit anderen Worten sind das erste Aperturelement unterhalb des Linsenelements und das weitere (zweite) Aperturelement oberhalb des Linsenelements angeordnet. Hierdurch ist einerseits das erste Aperturelement zu der Trägereinrichtung geringer beabstandet als das zweite Aperturelement. Andererseits sind die beiden Aperturelemente durch das Linsenelement voneinander beabstandet. Eine derartige Anordnung von Aperturelementen ist vorteilhaft, um durch jedes Aperturelement einen bestimmten optischen Zweck zu realisieren. Beispielsweise kann das erste (untere) Aperturelement dafür ausgelegt sein, eine Winkelcharakteristik des optischen Kanals (Neigung der optischen Achse des optischen Kanals relativ zu der Ebene der Trägereinrichtung und Öffnungswinkel) mitzubestimmen und/oder Streulicht innerhalb der optoelektronischen Vorrichtung zumindest zu reduzieren. Streulicht innerhalb der optoelektronischen Vorrichtung kann z.B. an der Trägereinrichtung reflektiertes Licht sein, welches nicht durch den optischen Kanal in die Messumgebung der Vorrichtung gelangen soll. Das zweite (obere) Aperturelement kann hingegen dazu ausgelegt sein, ein Eindringen von Streulicht aus der der Messumgebung in die Vorrichtung zu reduzieren oder zu blockieren. Auf diese Weise kann eine zweistufige optische Begrenzung der Strahlenbündel realisiert werden, welche besonders wirksam und dennoch einfach umsetzbar ist. Es versteht sich, dass die genannten Zwecke der Aperturelemente lediglich beispielhaft sind.

Nach einer weiteren Ausführungsform umfasst das erste optische Element ein Linsenelement, das zweite optische Element ein Aperturelement, und das dritte optische Element ein weiteres Linsenelement. Hierdurch kann insbesondere eine gewünschte Refraktionscharakteristik auf zwei optische Elemente verteilt werden.

Als weitere Alternative zu den vorstehend genannten Konfigurationen kann eines der drei optischen Elemente ein Linsenelement , ein anderes der drei optischen Elemente ein Aperturelement, und noch ein anderes der drei optischen Elemente ein Filterelement umfassen. Hierbei kann das Linsenelement beispielsweise durch das dritte optische Element (also das oberste der drei optischen Elemente) gebildet sein.

Es versteht sich, dass noch andere als die genannten Konfigurationen von optischen Elementen vorgesehen werden können. Insbesondere können auch mehr als drei optische Elemente eingesetzt werden. Vorzugsweise umfasst die Schichtanordnung zumindest ein Aperturelement und ein Linsenelement.

Gemäß einer weiteren Ausführungsform sind das erste optische Element sowie das zweite optische Element zwischen dem dritten optischen Element und der Trägereinrichtung in einer Vertikalrichtung gefangen, d.h. das erste und zweite optische Element sind zumindest in Vertikalrichtung indirekt an der Vorrichtung befestigt, sodass keine eigenständige Befestigung dieser optischen Elemente notwendig ist und die Komponenten der Vorrichtung einfach mit unterschiedlichen ersten und zweiten optischen Elementen kombiniert werden können. Hierfür können das erste und/oder zweite optische Element sowie weiteren Komponenten, insbesondere auch das dritte optische Element, zumindest abschnittsweise (z.B. an dem jeweiligen Umfang) komplementär zu der Halteeinrichtung ausgebildet sein.

Gemäß einer weiteren Ausführungsform weist wenigstens eines der wenigstens drei optischen Elemente zumindest eine Aufnahmevertiefung zum (teilweisen oder vollständigen) Aufnehmen eines anderen der wenigstens drei optischen Elemente auf. Vorzugsweise kann das erste und/oder dritte optische Element teilweise und/oder formschlüssig in einer Aufnahmevertiefung des zweiten optischen Elements aufgenommen werden. Die optoelektronische Vorrichtung kann hierdurch besonders kompakt ausgebildet werden, wobei das in die Aufnahmevertiefung aufgenommene erste und/oder dritte optische Element vorzugweise bündig mit einer äußeren Oberfläche des zweiten optischen Elements abschließt. Ferner kann durch die Aufnahmevertiefung die Position des ersten und/oder dritten optischen Elements relativ zu dem zweiten optischen Element (seitlich und/oder in Vertikalrichtung) besonders zuverlässig festgelegt werden, wobei die optischen Abschnitte (Linsenabschnitt, Aperturabschnitt, Filterabschnitt) der betreffenden optischen Elemente zur Herstellung des optischen Kanals exakt zueinander ausgerichtet sind, wenn das betreffende optische Element in der Aufnahmevertiefung aufgenommen ist.

Gemäß der Erfindung ist die Halteeinrichtung zweiteilig ausgebildet, wobei die Halteeinrichtung ein Unterteil sowie ein Oberteil aufweist. Das Unterteil und das Oberteil können hierbei insbesondere lösbar aneinander gesichert sein, wobei das Unterteil und/oder das Oberteil das erste optische Element, das zweite optische Element, die Trägereinrichtung und weitere optionale Komponenten der Vorrichtung umgreifen oder hintergreifen können. Das Unterteil der Halteeinrichtung kann einen Bodenabschnitt und mehrere hiervon nach oben abkragende Verbindungsabschnitte aufweisen. Ferner kann das Oberteil der Halteeinrichtung einen Deckelabschnitt und mehrere hiervon nach unten abkragende Verbindungsabschnitte aufweisen, die mit den Verbindungsabschnitten des Unterteils zusammenwirken. Das Unterteil und/oder das Oberteil können einen im Wesentlichen U-förmigen Querschnitt aufweisen, um einen Aufnahmeraum zumindest für die Trägereinrichtung und das erste und zweite optische Element zu bilden, welcher die Herstellung der Vorrichtung vereinfacht.

Die Trägereinrichtung, das erste optische Element und das zweite optische Element können zwischen dem Unterteil und dem Oberteil der Halteeinrichtung angeordnet und insbesondere zwischen dem Unterteil und dem Oberteil der Halteeinrichtung in einer Vertikalrichtung gefangen sein. Die optoelektronische Vorrichtung kann somit besonders effizient zusammengesetzt werden, da zumindest die Trägereinrichtung, das erste sowie das zweite optische Element nicht gesondert befestigt werden müssen. Gemäß der Erfindung sind die Trägereinrichtung, das erste optische Element und das zweite optische Element in das Unterteil eingelegt, wobei das Unterteil danach mit dem Oberteil verschlossen wird, und wobei die oberhalb der Trägereinrichtung eingelegten Komponenten hierdurch automatisch an der Trägereinrichtung fixiert sind.

Das Unterteil und das Oberteil der Halteeinrichtung können insbesondere mittels eines Rastschlusses aneinander befestigt sein.

Gemäß der Erfindung wird das dritte optische Element durch das Oberteil der Halteeinrichtung gebildet. Das dritte optische Element (z.B. Aperturelement) ist beispielsweise integral mit dem Oberteil der Halteeinrichtung ausgebildet, was hinsichtlich einer kompakten Bauform der optoelektronischen Vorrichtung und einer geringen Anzahl an Komponenten vorteilhaft ist.

Gemäß einer weiteren Ausführungsform weist eines der wenigstens drei optischen Elemente einen mechanischen Kodierabschnitt auf, der aus der Halteeinrichtung herausragt und der wenigstens ein Kodierelement zur Identifizierung der optoelektronischen Vorrichtung aufweist. Hierdurch können unterschiedliche Typen oder Arten von optoelektronischen Vorrichtungen insbesondere im Zuge ihrer Montage voneinander unterschieden werden. Dies ist z.B. dann vorteilhaft, wenn eine Vielzahl von unterschiedlichen optoelektronischen Vorrichtungen gemeinsam in einem (Drucker-) Gerät montiert werden müssen, wobei die Vorrichtungen aufgrund einer einheitlichen Modularität äußerlich ähnlich sind und deswegen leicht vertauscht werden könnten. Das Verwechslungsrisiko zwischen unterschiedlichen optoelektronischen Vorrichtungen wird durch den Kodierabschnitt jedoch effektiv reduziert.

Die Erfindung bezieht sich ferner auf ein System mit mehreren verschiedenen optoelektronischen Vorrichtungen nach einer der vorhergehenden Ausführungsformen, wobei die ersten optischen Elemente der mehreren verschiedenen optoelektronischen Vorrichtungen sich hinsichtlich ihrer Formgebung voneinander unterscheiden und/oder die zweiten optischen Elemente der mehreren verschiedenen optoelektronischen Vorrichtungen sich hinsichtlich ihrer Formgebung voneinander unterscheiden und/oder die dritten optischen Elemente der mehreren verschiedenen optoelektronischen Vorrichtungen sich hinsichtlich ihrer Formgebung voneinander unterscheiden. Die optischen Eigenschaften der verschiedenen Vorrichtungen können somit trotz eines modularen Aufbaus mit gleichartigen Elementen auf einfache Weise angepasst werden.

Die Erfindung bezieht sicher ferner auf ein System mit mehreren verschiedenen optoelektronischen Vorrichtungen nach einer der vorhergehenden Ausführungsformen, wobei - alternativ oder zusätzlich zu dem vorgenannten System - die optischen Elemente von wenigstens einigen der mehreren verschiedenen optoelektronischen Vorrichtungen sich hinsichtlich ihrer jeweiligen Anordnung voneinander unterscheiden, insbesondere hinsichtlich ihrer jeweiligen Reihenfolge entlang der genannten Vertikalrichtung.

Beispielsweise können wenigstens zwei der optischen Elemente einer jeweiligen optoelektronischen Vorrichtung ein jeweiliges Aperturelement umfassen, wobei die Aperturelemente von wenigstens einigen der verschiedenen optoelektronischen Vorrichtungen sich hinsichtlich ihrer jeweiligen Anordnung und/oder Formgebung von den Aperturelementen von anderen der verschiedenen optoelektronischen Vorrichtungen unterscheiden.

Vorzugsweise ist innerhalb eines der genannten Systeme wenigstens eine Komponente der verschiedenen optoelektronischen Vorrichtungen identisch ausgebildet, insbesondere die Halteeinrichtung und/oder die Trägereinrichtung (abgesehen von den hieran vorgesehenen optoelekronischen oder elektronischen Elementen, wie Sender, Empfänger und ASIC).

Die Erfindung wird nachfolgend rein beispielhaft anhand der Zeichnungen beschrieben, in denen:
- Fig. 1: eine Explosionsdarstellung einer optoelektronischen Vorrichtung gemäß der Erfindung ist;
- Fig. 2: eine Perspektivansicht von Komponenten der Vorrichtung von Fig. 1 ist;
- Fig. 3: eine Perspektivansicht der Vorrichtung von Fig. 1 in einem zusammengesetzten Zustand ist;
- Fig. 4: eine Draufsicht von oben auf ein Linsenelement der Vorrichtung von Fig. 1 ist;
- Fig. 5: zwei Perspektivansichten eines Montageorts für eine Vorrichtung gemäß Fig. 1, (a) ohne montierte Vorrichtung und (b) mit montierter Vorrichtung, umfasst;
- Fig. 6: zwei Perspektivansichten eines weiteren Montageorts für eine Vorrichtung gemäß Fig. 1, (a) ohne montierte Vorrichtung und (b) mit montierter Vorrichtung, umfasst;
- Fig. 7: eine schematische Längsschnittansicht einer optoelektronischen Vorrichtung ist, die nicht Teil der Erfindung ist;
- Fig. 8: eine schematische Längsschnittansicht einer weiteren optoelektronischen Vorrichtung ist; und
- Fig. 9: eine schematische Längsschnittansicht einer weiteren optoelektronischen Vorrichtung ist.

In den Zeichnungen sind gleiche oder gleichartige Elemente mit den gleichen Bezugszeichen gekennzeichnet.

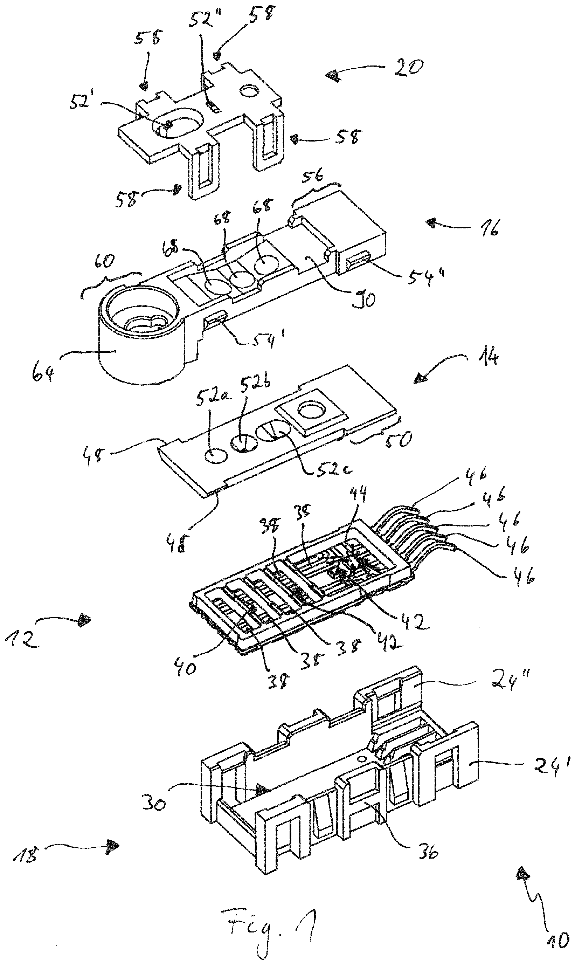

Eine optoelektronische Vorrichtung 10 gemäß der Erfindung umfasst eine Trägereinrichtung 12, ein erstes optisches Element in Form eines ersten Aperturelements 14, ein zweites optisches Element in Form eines Linsenelements 16 sowie eine ein Unterteil 18 sowie ein Oberteil 20 umfassende Halteeinrichtung. Das Oberteil 20 der Halteeinrichtung bildet bei dem hier gezeigten Ausführungsbeispiel gleichzeitig ein drittes optisches Element in Form eines weiteren Aperturelements der optoelektronischen Vorrichtung 10. Sämtliche dieser Komponenten sind in Fig. 1 von schräg oben gezeigt, d.h. die Perspektive ist schräg auf eine jeweilige Oberseite der Komponenten gerichtet.

Nachfolgend wird beschrieben, wie die Vorrichtung 10 zusammengesetzt wird, wobei die einzelnen Komponenten der optoelektronischen Vorrichtung 10 genauer erläutert werden.

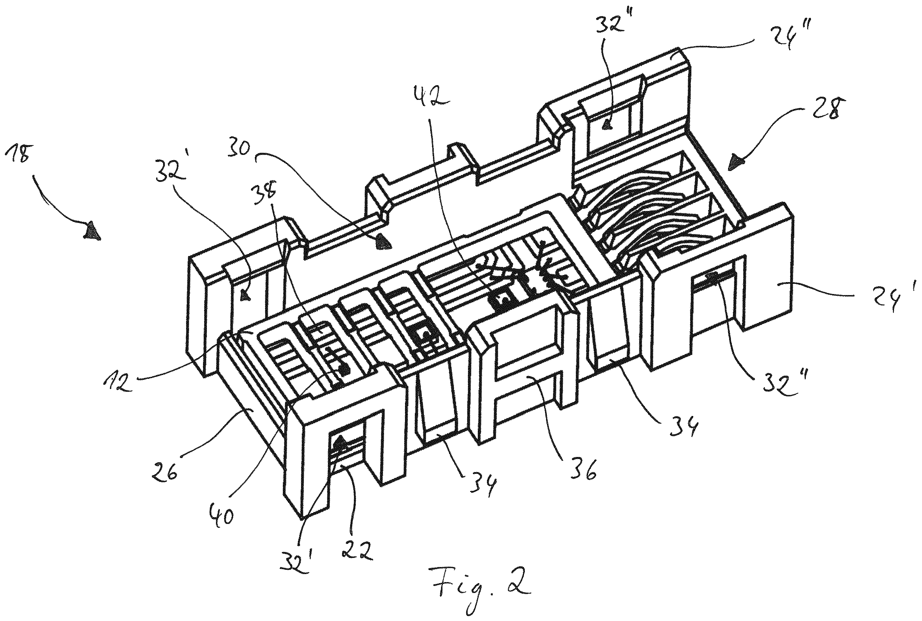

Zunächst wird die Trägereinrichtung 12 in das Unterteil 18 eingelegt. Das Unterteil 18 mit eingelegter Trägereinrichtung 12 ist in Fig. 2 dargestellt, wobei der Maßstab in Fig. 2 gegenüber Fig. 1 vergrößert ist. Das Unterteil 18 weist einen Bodenabschnitt 22 mit mehreren hiervon nach oben abkragenden Verbindungsabschnitten auf. Im Einzelnen erstrecken sich zwei bezüglich der Längserstreckung des Unterteils 18 spiegelsymmetrisch ausgebildete Seitenteile 24', 24" nach oben weg von dem Bodenabschnitt 22, wobei die Seitenteile 24', 24" im Wesentlichen senkrecht zu dem Bodenabschnitt 22 ausgerichtet sind. Ferner weist der Bodenabschnitt 22 einen stirnseitigen Riegel 26 sowie einen Kammabschnitt 28 auf. Das auf diese Weise U-förmig ausgebildete Unterteil 18 weist einen nach oben vollständig und seitlich teilweise geöffneten Aufnahmeraum 30 zur Aufnahme der Trägereinrichtung 12, des ersten Aperturelements 14 (erstes optisches Element) und des Linsenelements 16 (zweites optisches Element) auf. Die Größe und Form des Aufnahmeraums 30 entsprechen abschnittsweise im Wesentlichen der Größe und Form der Trägereinrichtung 12, des Aperturelements 14 und des Linsenelements 16. Die Komponenten 12, 14 und 16 können somit passgenau in das Unterteil 18 eingesetzt werden.

Die Seitenteile 24', 24" weisen jeweils zwei rechteckförmige Öffnungen 32' und 32" sowie zwei voneinander beabstandete, außenseitige Rastnasen 34 auf. Ferner weisen die Seitenteile 24', 24" jeweils einen zentral angeordneten, außenseitigen Rastriegel 36 auf. Der Aufnahmeraum 30 ist im Bereich des Kammabschnitts 28 gegenüber dem mittigen Bereich verbreitert.

Die Trägereinrichtung 12 ist als umspritzter Leiterrahmen ausgebildet (sogenannter "pre-molded leadframe"), der variabel bestückbar ist. Der Umfang der Trägereinrichtung 12 ist komplementär zu dem Aufnahmeraum 30 des Unterteils 18 ausgebildet, so dass die Trägereinrichtung 12 wie in Fig. 2 dargestellt in das Unterteil 18 eingelegt werden kann, wobei die Trägereinrichtung 12 in der Ebene des Bodenabschnitts 22 zwischen dem Riegel 26, dem Kammabschnitt 28 sowie den Seitenteilen 24', 24" seitlich gefangen ist. Die Oberseite der Trägereinrichtung 12 ist in Längsrichtung in mehrere Kammern 38 eingeteilt, wobei grundsätzlich in jeder Kammer 38 ein optoelektronischer Sender oder ein optoelektronischer Empfänger angebracht und elektrisch kontaktiert werden kann. Die in Fig. 1 dargestellte Trägereinrichtung 12 weist einen optoelektronischen Sender 40, zwei optoelektronische Empfänger 42 sowie einen ASIC 44 (Application-Specific-Integrated-Circuit) auf. Zur Anbindung der Trägereinrichtung 12 an einen externen Microcontroller (nicht gezeigt) sind mehrere elektrische Anschlüsse 46 vorgesehen, welche sich an einer Schmalseite der Trägereinrichtung 12 in einer einheitlichen Bogenform von der Trägereinrichtung 12 wegerstrecken. Wenn die Trägereinrichtung 12 in das Unterteil 18 eingelegt ist, greifen die Anschlüsse 46 rückfedernd in den Kammabschnitt 28 des Unterteils 18 ein, wodurch eine Kontaktierungszone für das Einführen eines elektrischen Steckverbinders (nicht gezeigt) gebildet ist (Fig. 2).

Nachdem die Trägereinrichtung 12 in das Unterteil 18 eingelegt wurde, wird das erste Aperturelement 14 (erstes optisches Element) in den Aufnahmeraum 30 des Unterteils 18 eingelegt (nicht gezeigt). Hierbei greift ein jeweiliger seitlicher Vorsprung 48 des ersten Aperturelements 14 in eine jeweilige Öffnung 32', 32" der Seitenteile 24', 24" ein (Fig. 1 und Fig. 2). Ferner greift ein verbreiterter Bereich 50 des ersten Aperturelements 14 in den im Bereich des Kammabschnitts 28 verbreiterten Aufnahmeraum 30 ein. Auf diese Weise ist das erste Aperturelement 14 insbesondere in Längsrichtung der Vorrichtung 10 nicht verschiebbar und diesbezüglich an dem Unterteil 18 gesichert. Das erste Aperturelement 14 in Fig. 1 weist ferner drei unterschiedlich ausgebildete Aperturabschnitte 52a, 52b und 52c auf, welche in Längsrichtung hintereinander an dem ersten Aperturelement 14 angeordnet sind und durch im Wesentlichen kegelstumpfförmig umrandete Öffnungen gebildet sind.

Als nächstes wird das Linsenelement 16 (zweites optisches Element) in den Aufnahmeraum 30 des Unterteils 18 eingelegt, wobei jeweils ein seitlicher Vorsprung 54', 54" in eine jeweilige Öffnung 32', 32" der Seitenteile 24', 24" eingreift. Ferner greift ein verbreiterter Bereich 56 des Linsenelements 16 in den im Bereich des Kammabschnitts 28 verbreiterten Bereich des Aufnahmeraums 30 ein. Das Linsenelement 16 ist auf diese Weise in Längs- und Querrichtung in einer Ebene parallel zu dem Bodenabschnitt 22 an dem Unterteil 18 fixiert.

Abschließend wird das Oberteil 20 der Halteeinrichtung mittels Rastschluss an dem Unterteil 18 befestigt, wobei das Oberteil 20 hierfür vier nach unten abkragende Rastlaschen 58 aufweist, welche jeweils mit einer der Rastnasen 34 der Seitenteile 24', 24" verrasten. Die Trägereinrichtung 12, das Aperturelement 14 und das Linsenelement 16 sind nun zwischen dem Oberteil 20 und dem Unterteil 18 vollständig gefangen und aneinander fixiert. Das Unterteil 18 der Halteeinrichtung, die Trägereinrichtung 12, das Aperturelement 14, das Linsenelement 16 und das Oberteil 20 der Halteeinrichtung sind somit entlang einer Vertikalrichtung hintereinander angeordnet.

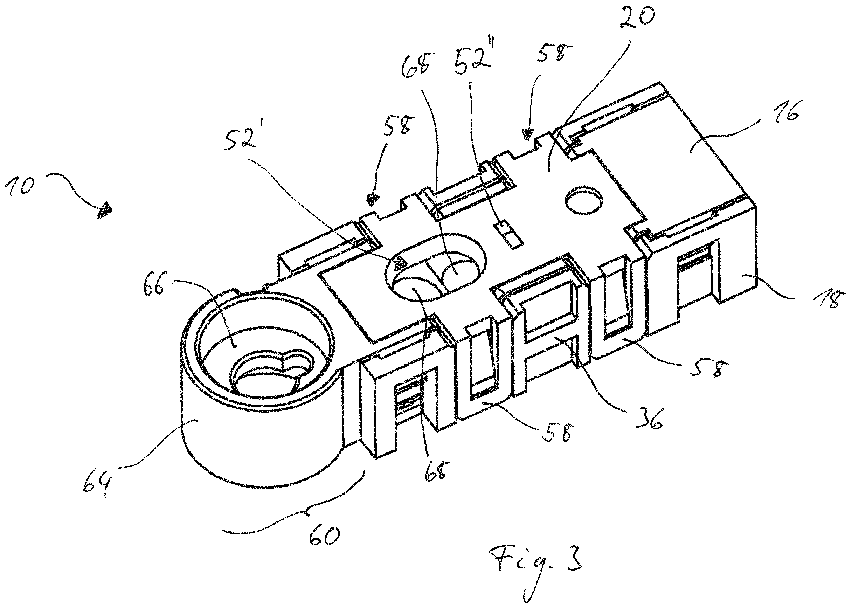

Die derart zusammengesetzte Vorrichtung 10 ist in Fig. 3 perspektivisch dargestellt. Das Oberteil 20 (weiteres Aperturelement bzw. drittes optisches Element der Vorrichtung 10) weist zwei Aperturabschnitte 52', 52" auf (vgl. Fig. 1 und Fig. 3). Ferner ist erkennbar, dass das Oberteil 20 in einen komplementären Eingriffsabschnitt 90 des Linsenelements 16 (vgl. Fig. 1) eingreift, sodass das Oberteil 20 bündig mit dem Linsenelement 16 abschließt und eine im Wesentlichen glatte Oberseite der Vorrichtung 10 gebildet ist. Darüber hinaus wird das Linsenelement 16 zusätzlich fixiert und die Größe der Vorrichtung 10 klein gehalten.

Durch die drei Aperturabschnitte 52a, 52b und 52c des ersten Aperturelements 14 in Kombination mit den zwei Aperturabschnitten 52', 52" des weiteren Aperturelements bzw. Oberteils 20 werden die optischen Eigenschaften der optoelektronischen Vorrichtung 10 festgelegt und unerwünschte Störeinflüsse unterdrückt, indem eine geometrische Begrenzung des jeweiligen Querschnitts der emittierten oder empfangenen Strahlenbündel erfolgt.

Die Vorrichtung 10 besitzt einen schlanken, im Wesentlichen quaderförmigen Grundkörper, wobei die Außenhaut der Vorrichtung sich durch im Wesentlichen bündig miteinander abschließende Flächen auszeichnet. Insbesondere schließen die Rastlaschen 58 bündig mit der Außenseite der Seitenteile 24', 24" ab.

Das im Wesentlichen plattenförmige Linsenelement 16 (zweites optisches Element der Vorrichtung 10) weist einen integral ausgebildeten, mechanischen Kodierabschnitt 60 auf, welcher sich in Längsrichtung von dem ansonsten plattenförmig ausgebildeten Linsenelement 16 weg erstreckt (Fig. 1). Der ringförmig ausgebildete Kodierabschnitt 60 weist einen Hohlzylinder 64 auf, welcher senkrecht von einer Erstreckungsebene von drei in Längsrichtung hintereinander angeordneten Linsenabschnitten 68 des Linsenelements 16 abkragt. Die Linsenabschnitte 68 des Linsenelements 16 weisen bei dem hier gezeigten Ausführungsbeispiel strahlformende Eigenschaften auf und können beispielsweise Konvex-Linsen, Bikonvex-Linsen oder Fresnel-Linsen umfassen.

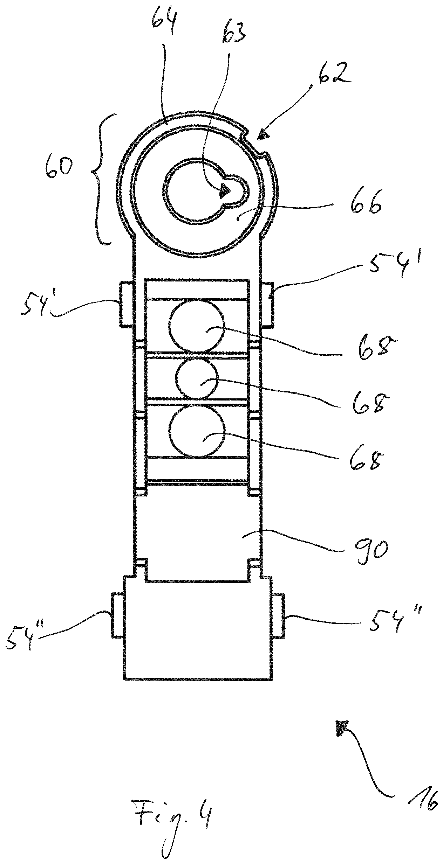

Weitere Details zu dem Linsenelement 16 sind in Fig. 4 gezeigt, in der das Linsenelements 16 in einer Draufsicht auf die Oberseite des Linsenelements 16 dargestellt ist. Das in Fig. 4 gezeigte Linsenelement 16 weist an dem Kodierabschnitt 60 ein erstes Kodierelement 62 und ein zweites Kodierelement 63 auf. Das erste Kodierelement 62 ist als rechteckförmige Vertiefung an dem Außenumfang des Hohlzylinders 64 des Kodierabschnitts 60 ausgebildet, wobei sich das erste Kodierelement 62 parallel zu der Zylinderachse (in Fig. 4 senkrecht zur Papierebene) erstreckt, sodass sich eine rechteckförmige Nut in dem Zylindermantel des Hohlzylinders 64 ergibt. Innerhalb des Hohlzylinders 64 erstreckt sich senkrecht zu dessen Längsachse eine Ringscheibe 66. An dem Innenumfang der Ringscheibe 66 ist das zweite Kodierelement 63 vorgesehen, welches als im Wesentlichen halbkreisförmige Vertiefung ausgebildet ist und sich parallel zu der Zylinderachse als Rundnut erstreckt.

Das erste Kodierelement 62 ist lediglich beispielhaft dafür vorgesehen, die zugrundeliegende Vorrichtung 10 bezüglich eines Vorrichtungstyps zu identifizieren. Ein Vorrichtungstyp ist insbesondere durch die jeweilige Ausbildung des Linsenelements 16, des Oberteils 20 und/oder des ersten Aperturelements 14 sowie durch die Bestückung der Trägereinrichtung 12 mit optoelektronischen Sendern 40 bzw. Empfängern 42 charakterisiert. Hierbei können sich insbesondere die Position und die Ausbildung von Linsenabschnitten 68 der Linsenelemente 16 unterscheiden. Das zweite Kodierelement 63 ist dafür vorgesehen, die Vorrichtung 10 bezüglich eines Bus zu identifizieren, der zur Anbindung der Trägereinrichtung 12 an einen Microcontroller vorgesehen ist.

Diese Aufzählung ist lediglich beispielhaft. Grundsätzlich können die Kodierelemente 62, 63 die optoelektronische Vorrichtung 10 bezüglich frei definierbarer Merkmale identifizieren. Die Kodierelemente 62, 63 sind neben ihrer Form lediglich in Abhängigkeit ihrer Winkelstellung um die Längsachse des Hohlzylinders 64 definiert, wobei die Winkelstellung des jeweiligen Kodierelements 62, 63 eine eindeutige Identifizierung der Vorrichtung 10 bezüglich des dem jeweiligen Kodierelement 62, 63 zugeordneten Merkmals ermöglicht.

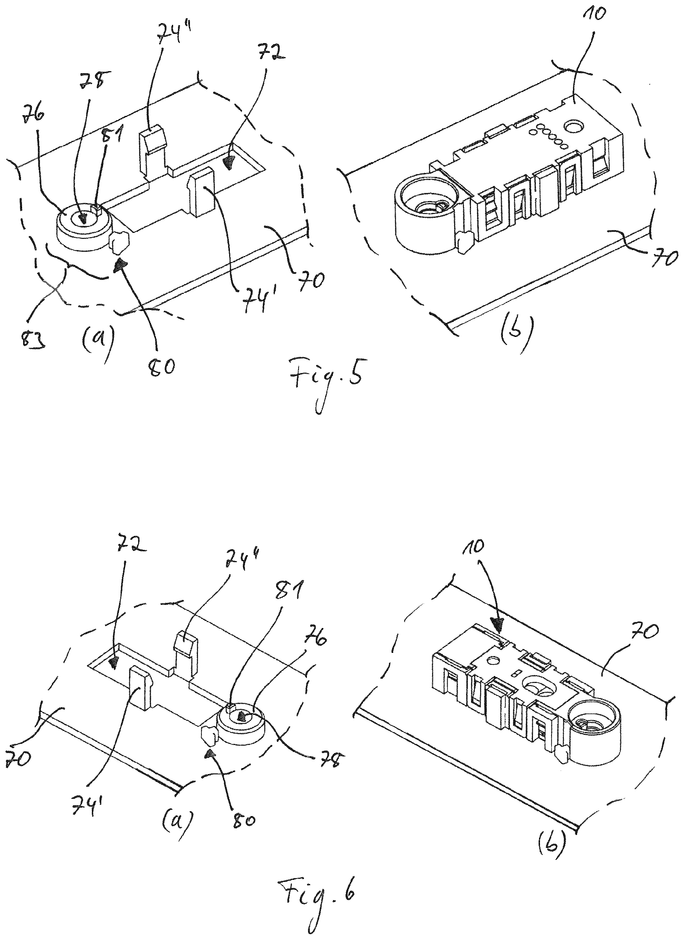

In Fig. 5 sind zwei Perspektivansichten eines Montageorts für eine optoelektronische Vorrichtung 10 gezeigt, der im Zusammenhang mit der Erfindung auch als Montageumgebung der optoelektronischen Vorrichtung 10 bezeichnet wird. In Fig. 5 (a) ist der Montageort als solcher gezeigt, d.h. ohne dass eine betreffende Vorrichtung 10 montiert ist. Der Montageort ist gekennzeichnet durch einen Abschnitt einer Grundplatte 70 mit einer rechteckförmigen Öffnung 72, an deren inneren Längskanten zwei einander gegenüberliegende Rastarme 74', 74" vorgesehen sind. Benachbart zu einer Schmalseite der Öffnung 72 ist ein Zylinder 76 ausgebildet, der sich senkrecht zu der Ebene der Grundplatte 70 erstreckt und mit einer zentralen Öffnung 78 versehen ist. Die Öffnung 78 kann ein Innengewinde für eine nicht gezeigte Schraube aufweisen.

Der Zylinder 76 weist ein erstes Dekodierelement 80 und ein zweites Dekodierelement 81 auf. Das erste Dekodierelement 80 ist T-förmig ausgebildet und von der Mantelfläche des Zylinders 76 in radialer Richtung beabstandet. Die Höhe des Dekodierelements 80 ist geringer als die Höhe des Zylinders 76. Das zweite Dekodierelement 81 ist an der Stirnseite des Zylinders 76 ausgebildet und weist abschnittsweise eine zylindrische Form auf. Der Zylinder 76 sowie die Dekodierelemente 80 und 81 bilden zusammen einen Dekodierabschnitt 83 für den Kodierabschnitt 60 einer Vorrichtung 10. Der Dekodierabschnitt 83 ist einteilig mit der Grundplatte 70 ausgebildet. Die Kanten des Zylinders 76 sowie der Dekodierelemente 80 und 81 weisen eine jeweilige Fase auf, welche die Montage der Vorrichtung 10 erleichtert.

Die an dem in Fig. 5 (a) gezeigten Montageort zu montierende Vorrichtung 10 wird mit der Oberseite der Vorrichtung 10 voraus montiert, so dass die Vorrichtung 10 die in Fig. 5 (b) dargestellte Position einnimmt, in der die Oberseite der Vorrichtung 10 der Öffnung 72 der Grundplatte 70 zugewandt ist. Durch den Dekodierabschnitt 83 ist sichergestellt, dass nur diejenige Vorrichtung 10 montiert werden kann, die einen komplementär zu dem Dekodierabschnitt 83 ausgebildeten Kodierabschnitt 60 aufweist, welcher die Montage der Vorrichtung 10 an dem betreffenden Montageort durch Formschluss eindeutig festlegt. Im montierten Zustand greift das erste Kodierelement 62 in das erste Dekodierelement 80 ein. Ferner greift das zweite Kodierelement 63 abschnittsweise in das zweite Dekodierelement 81 ein. Darüber hinaus sind die Rastarme 74', 74" mit den Rastriegeln 36 des Unterteils 18 verrastet, so dass die Vorrichtung 10 sicher an der Grundplatte 70 befestigt ist.

In Fig. 6 ist ein weiterer Montageort für eine Vorrichtung 10 gezeigt, wobei die Vorrichtung 10 im Gegensatz zu dem Fall von Fig. 5 (b) in Fig. 6 (b) umgekehrt montiert ist, d.h. die strahlungsemittierende bzw. strahlungsempfangende Oberseite der Vorrichtung 10 ist der Grundplatte 70 abgewandt. Die Vorrichtung 10 kann somit flexibel auf unterschiedliche Weise an einem im Wesentlichen gleich ausgebildeten Montageort montiert werden, wobei hierfür lediglich die Positionen der Kodierelemente 62, 63 und die Positionen der Dekodierelemente 80, 81 aufeinander abgestimmt sein müssen (vgl. Fig. 5 (a) und Fig. 6 (a)).

Vorzugsweise ist die Grundform des Kodierabschnitts 60 (insbesondere der Hohlzylinder 64 mit Ringscheibe 66) bezüglich einer Mittenebene der optoelektronischen Vorrichtung 10, die senkrecht zu der Vertikalrichtung steht, symmetrisch ausgebildet. Ferner ist es bevorzugt, wenn eine Befestigungseinrichtung zum Befestigen der optoelektronischen Vorrichtung 10 an einer Montageumgebung (insbesondere die Rastriegel 36 der Halteeinrichtung für die Rastarme 74', 74" der Grundplatte 70) bezüglich einer Mittenebene der optoelektronischen Vorrichtung 10, die senkrecht zu der Vertikalrichtung steht, symmetrisch ausgebildet ist. Hierdurch kann die Vorrichtung 10 besonders einfach wahlweise in einer von zwei verschiedenen Ausrichtungen ihrer Oberseite an der Montageumgebung befestigt werden, wie anhand der Fig. 5 und 6 erläutert wurde.

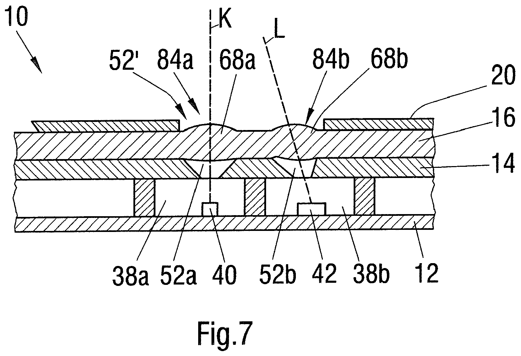

Fig. 7 gibt eine Längsschnittansicht einer weiteren beispielhaften optoelektronischen Vorrichtung 10 wieder, die nicht Teil der Erfindung ist. Der Sandwichaufbau entspricht demjenigen der in Fig. 1 gezeigten optoelektronischen Vorrichtung 10, wobei in Fig. 7 abschnittsweise eine Trägereinrichtung 12, ein erstes optisches Element in Form eines ersten Aperturelements 14, ein zweites optisches Element in Form eines Linsenelements 16 sowie ein drittes optisches Element in Form eines weiteren Aperturelements 20 mit einem Aperturabschnitt 52' gezeigt sind. Die Trägereinrichtung 12, das erste Aperturelement 14, das Linsenelement 16 sowie das weitere Aperturelement 20 (drittes optisches Element) werden von einer Halteeinrichtung (nicht gezeigt) relativ zueinander gehalten, wobei diese Halteeinrichtung einteilig und im Übrigen im Wesentlichen wie das Unterteil 18 gemäß Fig. 1 ausgebildet sein kann. In einer Kammer 38a der Trägereinrichtung 12 befindet sich ein optoelektronischer Sender 40. In einer benachbarten Kammer 38b befindet sich ein optoelektronischer Empfänger 42. Oberhalb des Senders 40 erstreckt sich ein optischer Kanal 84a, dessen Achse K im Wesentlichen senkrecht zu der Erstreckungsebene der Trägereinrichtung 12 durch den Sender 40 verläuft. Oberhalb des Empfängers 42 erstreckt sich ein optischer Kanal 84b, dessen Achse L geneigt zu der Erstreckungsebene der Trägereinrichtung 12 durch den Empfänger 42 verläuft.

Der Aperturabschnitt 52' des weiteren Aperturelements 20 erstreckt sich in horizontaler Richtung über beide optischen Kanäle 84a und 84b und vermindert einen unerwünschten Strahlungseintrag in das Linsenelement 16 aus seitlichen Richtungen, d.h. Richtungen, die stark von den Verläufen der Achsen K und L abweichen. Die optischen Kanäle 84a, 84b umfassen in der Ebene des Linsenelements 16 jeweils einen Linsenabschnitt 68a, 68b. Unterhalb der Linsenabschnitte 68a, 68b ist an dem ersten Aperturelement 14 jeweils ein im Wesentlichen kegelstumpfförmiger Aperturabschnitt 52a, 52b vorgesehen. Der eine Aperturabschnitt 52a ist durch eine im Wesentlichen rotationssymmetrische, kegelstumpfförmige Öffnung in dem ersten Aperturelement 14 gebildet. Der andere Aperturabschnitt 52b ist durch eine gescherte, kegelstumpfförmige Öffnung in dem ersten Aperturelement 14 gebildet, wodurch die Achse L des optischen Kanals 84b gegenüber der Trägereinrichtung 12 geneigt ist. Die optischen Eigenschaften können durch das erste Aperturelement 14 und das zweiten Aperturelement 20, welche sich in voneinander verschiedenen Vertikallagen befinden, besonders effektiv angepasst werden.

Insbesondere kann der seitliche Einfall von Streulicht in die optischen Kanäle 84a, 84b durch das Oberteil 20 im Wesentlichen unabhängig von den querschnittsbegrenzenden Eigenschaften des ersten Aperturelements 14 reguliert werden. Somit kann es z.B. ausreichend sein, lediglich das erste Aperturelement 14 auszutauschen, um eine gewünschte Winkelcharakteristik für einen optischen Kanal 84 zu realisieren.

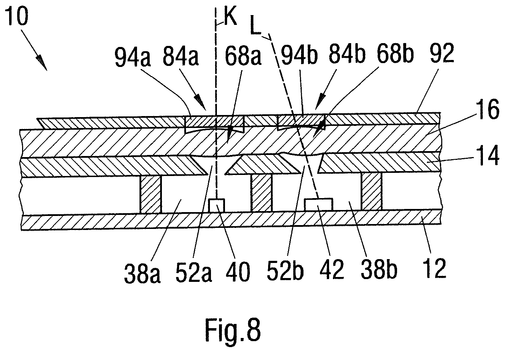

In Fig. 8 ist eine Längsschnittansicht einer weiteren optoelektronischen Vorrichtung 10 gezeigt, welche ähnlich zu derjenigen von Fig. 7 ausgebildet ist. Abweichend zu der Vorrichtung von Fig. 7 ist oberhalb des ersten Aperturelements 14 (erstes optisches Element) und des Linsenelements 16 (zweites optisches Element) ein drittes optisches Element in Form eines Filterelements 92 angeordnet, welches zwei planparallele Filterabschnitte 94 aufweist. Die Filterabschnitte 94 besitzen spektrale Filtereigenschaften (z.B. Infrarot-Bandpass), wobei der Filterabschnitt 94a mit dem ersten optischen Kanal 84a und der Filterabschnitt 94b mit dem zweiten optischen Kanal 84b fluchtet. Das Filterelement 92 kann gemäß der Erfindung als Oberteil einer zweiteiligen Halteeinrichtung ausgebildet sein, oder das Filterelement 92 ist gemäß einer nicht zu der Erfindung gehörenden Ausführungsform separat von einer einteiligen Halteeinrichtung (z.B. Unterteil 18 gemäß Fig. 1) ausgebildet, wobei das Filterelement 92 ein Abschlussfenster der einteiligen Halteeinrichtung bilden kann (Halteeinrichtung in Fig. 8 nicht gezeigt).

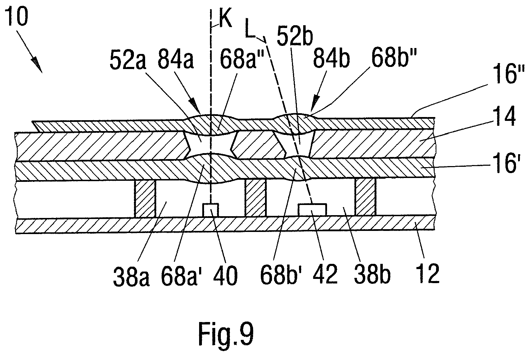

Eine weitere mögliche Ausführungsform ist in Fig. 9 gezeigt. Dort umfasst das erste optische Element ein Linsenelement 16' mit zwei Linsenabschnitten 68'a und 68'b. Das oberhalb davon angeordnete zweite optische Element umfasst ein Aperturelement 14, welches zwei ähnlich wie in Fig. 7 und 8 ausgebildete Aperturabschnitte 52a und 52b aufweist. Schließlich umfasst das dritte optische Element ein weiteres Linsenelement 16" mit zwei Linsenabschnitten 68"a und 68"b, welche im Vergleich zu den Linsenabschnitten 68'a und 68'b dünner ausgebildet sind. Das Linsenelement 16" kann gemäß der Erfindung als Oberteil einer zweiteiligen Halteeinrichtung oder gemäß einer nicht zu der Erfindung gehörenden Ausführungsform separat von einer einteiligen Halteeinrichtung ausgebildet sein (Halteeinrichtung in Fig. 9 nicht gezeigt). Sofern das Linsenelement 16" separat ausgebildet ist, kann dieses mittels Rastschluss an der Halteeinrichtung befestigt sein und gleichzeitig die Oberseite der Vorrichtung 10 bilden.

Zu den erläuterten Ausführungsbeispielen ist noch anzumerken, dass die Trägereinrichtung 12 variabel bestückt werden kann, insbesondere mit verschiedenen Anzahlen von optoelektronischen Sendern 40 und/oder optoelektronischen Empfängern 42. Durch die modulare Bauweise der jeweiligen optoelektronischen Vorrichtung 10 ist eine einfache Anpassung an unterschiedliche Anwendungen möglich, wobei durch Austauschen einzelner Komponenten (Aperturelement 14, 20, Filterelement 92 oder Linsenelement 16) insbesondere auch eine der Anzahl von Sendern 40 und Empfängern 42 entsprechende Anzahl von Aperturabschnitten 52, Linsenabschnitten 68 oder Filterabschnitten 94 vorgesehen werden kann.

### Bezugszeichenliste

- 10: optoelektronische Vorrichtung
- 12: Trägereinrichtung
- 14: erstes Aperturelement
- 16: Linsenelement
- 18: Unterteil
- 20: Oberteil bzw. zweites Aperturelement
- 22: Bodenabschnitt
- 24: Seitenteil
- 26: Riegel
- 28: Kammabschnitt
- 30: Aufnahmeraum
- 32: Öffnung
- 34: Rastnasen
- 36: Rastriegel
- 38: Kammer
- 40: Sender
- 42: Empfänger
- 44: ASIC
- 46: Anschluss
- 48: Vorsprung
- 50: Bereich
- 52: Aperturabschnitt
- 54: Vorsprung
- 56: Bereich
- 58: Rastlaschen
- 60: Kodierabschnitt
- 62: erstes Kodierelement
- 63: zweites Kodierelement
- 64: Hohlzylinder
- 66: Ringscheibe
- 68: Linsenabschnitt
- 70: Grundplatte
- 72: Öffnung
- 74: Rastarm
- 76: Zylinder
- 78: Öffnung
- 80: erstes Dekodierelement
- 81: zweites Dekodierelement
- 83: Dekodierabschnitt
- 84: optischer Kanal
- 90: Eingriffsabschnitt
- 92: Filterelement
- 94: Filterabschnitt

- K: Achse
- L: Achse

## Patentansprüche

1. Optoelektronische Vorrichtung (10), mit:
einer Trägereinrichtung (12), die an einer Oberseite wenigstens einen optoelektronischen Sender (40) und wenigstens einen optoelektronischen Empfänger (42) aufweist;
wenigstens einem ersten optischen Element, einem zweiten optischen Element und einem dritten optischen Element, die als separate optische Elemente zu einer Schichtanordnung oberhalb der Trägereinrichtung (12) zusammengesetzt sind, wobei das zweite optische Element oberhalb des ersten optischen Elements angeordnet ist und das dritte optische Element oberhalb des zweiten optischen Elements angeordnet ist, und wobei jedes der wenigstens drei optischen Elemente ein Linsenelement (16), ein Aperturelement (14) oder ein Filterelement (92) umfasst; und
einer Halteeinrichtung, die wenigstens das erste optische Element und das zweite optische Element relativ zu der Trägereinrichtung (12) hält und teilweise umgibt,
wobei die Halteeinrichtung zweiteilig ausgebildet ist, und wobei die Halteeinrichtung ein Unterteil (18) sowie ein Oberteil (20) umfasst,
wobei das erste optische Element (16) sowie das zweite optische Element (14) zwischen dem Unterteil (18) und dem Oberteil (20) der Halteeinrichtung gefangen sind,
wobei das dritte optische Element durch das Oberteil (20) der Halteeinrichtung gebildet ist,
wobei die Trägereinrichtung sowie das erste optische Element und das zweite optische Element in das Unterteil eingelegt sind,
**dadurch gekennzeichnet,**
**dass** auch die Trägereinrichtung (12) zwischen dem Unterteil (18) und dem Oberteil (20) der Halteeinrichtung gefangen ist,
wobei das Oberteil das Unterteil verschließt und das erste optische Element und das zweite optische Element an der Trägereinrichtung fixiert.

2. Optoelektronische Vorrichtung (10) nach Anspruch 1,
wobei eines der wenigstens drei optischen Elemente oder mehrere der wenigstens drei optischen Elemente gemeinsam einen optischen Kanal (84) für den wenigstens einen optoelektronischen Sender (40) und/oder den wenigstens einen optoelektronischen Empfänger (42) bilden.

3. Optoelektronische Vorrichtung (10) nach Anspruch 1 oder 2,
wobei zumindest eines der drei optischen Elemente ein Linsenelement (16) umfasst, wobei das Linsenelement (16) einen Linsenabschnitt (68) für den wenigstens einen optoelektronischen Sender (40) und/oder einen Linsenabschnitt (68) für den wenigstens einen optoelektronischen Empfänger (42) aufweist.

4. Optoelektronische Vorrichtung (10) nach einem der vorherigen Ansprüche ,
wobei zumindest eines der drei optischen Elemente ein Aperturelement (14, 20) umfasst, wobei das Aperturelement (14, 20) einen Einfallswinkelbereich für optische Strahlen definiert, welche auf den wenigstens einen optoelektronischen Empfänger (42) eintreffen, und/oder einen Emissionswinkelbereich für optische Strahlen definiert, welche von dem wenigstens einen optoelektronischen Sender (40) emittiert werden.

5. Optoelektronische Vorrichtung (10) nach einem der Ansprüche 1 bis 3,
wobei zumindest eines der drei optischen Elemente ein Aperturelement (14, 20) umfasst, wobei das Aperturelement (14, 20) einen Aperturabschnitt (52) für den wenigstens einen optoelektronischen Sender (40) und/oder einen Aperturabschnitt (52) für den wenigstens einen optoelektronischen Empfänger (42) aufweist.

6. Optoelektronische Vorrichtung (10) nach Anspruch 5,
wobei der Aperturabschnitt (52) einen sich in Richtung zu der Trägereinrichtung (12) verjüngenden Querschnitt aufweist; und/oder
wobei der Aperturabschnitt (52) durch eine zumindest im Wesentlichen kegelstumpfförmige Öffnung gebildet ist.

7. Optoelektronische Vorrichtung (10) nach einem der vorherigen Ansprüche,
wobei zumindest eines der drei optischen Elemente ein Filterelement (92) umfasst, wobei das Filterelement (92) einen planparallelen Filterabschnitt (94) aufweist, der spektrale Filtereigenschaften besitzt.

8. Optoelektronische Vorrichtung (10) nach einem der vorherigen Ansprüche,
wobei das erste optische Element ein erstes Aperturelement (14) umfasst, das zweite optische Element ein Linsenelement (16) umfasst, und das dritte optische Element ein weiteres Aperturelement (20) umfasst.

9. Optoelektronische Vorrichtung (10) nach einem der Ansprüche 1 bis 7,
wobei das erste optische Element ein Linsenelement (16) umfasst, das zweite optische Element ein Aperturelement (14) umfasst, und das dritte optische Element ein weiteres Linsenelement (16) umfasst.

10. Optoelektronische Vorrichtung (10) nach einem der Ansprüche 1 bis 7,
wobei eines der wenigstens drei optischen Elemente ein Linsenelement (16) umfasst, ein anderes der wenigstens drei optischen Elemente ein Aperturelement (14) umfasst, und noch ein anderes der wenigstens drei optischen Elemente ein Filterelement (92) umfasst.

11. Optoelektronische Vorrichtung (10) nach einem der vorherigen Ansprüche,
wobei das erste optische Element (14) und/oder das zweite optische Element (16) zwischen dem dritten optischen Element (20) und der Trägereinrichtung (12) in einer Vertikalrichtung gefangen sind.

12. Optoelektronische Vorrichtung (10) nach einem der vorherigen Ansprüche,
wobei wenigstens eines der wenigstens drei optischen Elemente zumindest eine Aufnahmevertiefung (90) zum Aufnehmen eines anderen der wenigstens drei optischen Elemente aufweist.

13. Optoelektronische Vorrichtung (10) nach einem der vorherigen Ansprüche,
wobei das Unterteil (18) und das Oberteil (20) der Halteeinrichtung mittels eines Rastschlusses aneinander befestigt sind.

14. Optoelektronische Vorrichtung (10) nach einem der vorherigen Ansprüche,
wobei eines der wenigstens drei optischen Elemente einen mechanischen Kodierabschnitt (60) aufweist, der aus der Halteeinrichtung herausragt und der wenigstens ein Kodierelement (62, 63) zur Identifizierung der optoelektronischen Vorrichtung (10) aufweist.

15. System mit mehreren verschiedenen optoelektronischen Vorrichtungen (10) nach einem der vorhergehenden Ansprüche,
wobei die ersten optischen Elemente der mehreren verschiedenen optoelektronischen Vorrichtungen (10) sich hinsichtlich ihrer Formgebung voneinander unterscheiden und/oder die zweiten optischen Elemente der mehreren verschiedenen optoelektronischen Vorrichtungen (10) sich hinsichtlich ihrer Formgebung voneinander unterscheiden und/oder die dritten optischen Elemente der mehreren verschiedenen optoelektronischen Vorrichtungen (10) sich hinsichtlich ihrer Formgebung voneinander unterscheiden.

## Claims

1. An optoelectronic apparatus (10), comprising:
a carrier device (12) which has at least one optoelectronic transmitter (40) and at least one optoelectronic receiver (42) at an upper side;
at least one first optical element, a second optical element and a third optical element which are assembled as separate optical elements to form a layer arrangement above the carrier device (12), with the second optical element being arranged above the first optical element and the third optical element being arranged above the second optical element, and with each of the at least three optical elements comprising a lens element (16), an aperture element (14) or a filter element (92); and
a holding device which holds at least the first optical element and the second optical element relative to the carrier device (12) and partly surrounds at least the first optical element and the second optical element,
wherein the holding device is formed in two parts, and wherein the holding device comprises a lower part (18) and an upper part (20);
wherein the first optical element (16) and the second optical element (14) are captured between the lower part (18) and the upper part (20) of the holding device;
wherein the third optical element is formed by the upper part (20) of the holding device; and
wherein the carrier device, the first optical element and the second optical element are placed into the lower part,
**characterized in that**
the carrier device (12) is also captured between the lower part (18) and the upper part (20) of the holding device,
with the upper part closing the lower part and fixing the first optical element and the second optical element to the carrier device.

2. An optoelectronic apparatus (10) in accordance with claim 1,
wherein one of the at least three optical elements or a plurality of the at least three optical elements together forms/form an optical channel (84) for the at least one optoelectronic transmitter (40) and/or for the at least one optoelectronic receiver (42).

3. An optoelectronic apparatus (10) in accordance with claim 1 or claim 2,
wherein at least one of the three optical elements comprises a lens element (16), with the lens element (16) having a lens section (68) for the at least one optoelectronic transmitter (40) and/or a lens section (68) for the at least one optoelectronic receiver (42).

4. An optoelectronic apparatus (10) in accordance with any one of the preceding claims,
wherein at least one of the three optical elements comprises an aperture element (14, 20), with the aperture element (14, 20) defining an angular range of incidence for optical beams which are incident onto the at least one optoelectronic receiver (42) and/or defining an angular range of emission for optical beams which are emitted by the at least one optoelectronic transmitter (40).

5. An optoelectronic apparatus (10) in accordance with any one of the claims 1 to 3,
wherein at least one of the three optical elements comprises an aperture element (14, 20), with the aperture element (14, 20) having an aperture section (52) for the at least one optoelectronic transmitter (40) and/or an aperture section (52) for the at least one optoelectronic receiver (42).

6. An optoelectronic apparatus (10) in accordance with claim 5,
wherein the aperture section (52) has a cross-section tapering in the direction toward the carrier device (12); and/or
wherein the aperture section (52) is formed by an least substantially frustoconical opening.

7. An optoelectronic apparatus (10) in accordance with any one of the preceding claims,
wherein at least one of the three optical elements comprises a filter element (92), with the filter element (92) having a planoparallel filter section (94) which has spectral filter properties.

8. An optoelectronic apparatus (10) in accordance with any one of the preceding claims,
wherein the first optical element comprises a first aperture element (14), the second optical element comprises a lens element (16) and the third optical element comprises a further aperture element (20).

9. An optoelectronic apparatus (10) in accordance with any one of the claims 1 to 7,
wherein the first optical element comprises a lens element (16), the second optical element comprises an aperture element (14) and the third optical element comprises a further lens element (16).

10. An optoelectronic apparatus (10) in accordance with any one of the claims 1 to 7,
wherein one of the at least three optical elements comprises a lens element (16), another one of the at least three optical elements comprises an aperture element (14) and yet another one of the at least three optical elements comprises a filter element (92).

11. An optoelectronic apparatus (10) in accordance with any one of the preceding claims,
wherein the first optical element (14) and/or the second optical element (16) is/are captured between the third optical element (20) and the carrier device (12) in a vertical direction.

12. An optoelectronic apparatus (10) in accordance with any one of the preceding claims,
wherein at least one of the at least three optical elements has at least one receiving recess (90) for receiving another one of the at least three optical elements.

13. An optoelectronic apparatus (10) in accordance with any one of the preceding claims,
wherein the lower part (18) and the upper part (20) of the holding device are fastened to one another by means of a latching connection.

14. An optoelectronic apparatus (10) in accordance with any one of the preceding claims,
wherein one of the at least three optical elements has a mechanical coding section (60) which projects out of the holding device and which has at least one coding element (62, 63) for identifying the optoelectronic apparatus (10).

15. A system comprising a plurality of different optoelectronic apparatus (10) in accordance with any one of the preceding claims,
wherein the first optical elements of the plurality of different optoelectronic apparatus (10) differ from one another with respect to their shape and/or the second optical elements of the plurality of different optoelectronic apparatus (10) differ from one another with respect to their shape and/or the third optical elements of the plurality of different optoelectronic apparatus (10) differ from one another with respect to their shape.

## Revendications

1. Dispositif optoélectronique (10), comportant
un moyen porteur (12) comprenant sur une face supérieure au moins un émetteur optoélectronique (40) et au moins un récepteur optoélectronique (42) ;
au moins un premier élément optique, un second élément optique et un troisième élément optique qui, en tant qu'éléments optiques séparés, sont composés en une disposition en couches au-dessus du moyen porteur (12), le second élément optique étant disposé au-dessus du premier élément optique et le troisième élément optique étant disposé au-dessus du second élément optique, et chacun desdits au moins trois éléments optiques comprenant un élément de lentille (16), un élément d'ouverture (14) ou un élément de filtre (92) ; et
un moyen de maintien qui maintient au moins le premier élément optique et le second élément optique par rapport au moyen porteur (12), et qui les entoure partiellement,
le moyen de maintien étant réalisé en deux parties,
le moyen de maintien comprenant une partie inférieure (18) et une partie supérieure (20),
le premier élément optique (16) ainsi que le second élément optique (14) étant emprisonnés entre la partie inférieure (18) et la partie supérieure (20) du moyen de maintien,
le troisième élément optique étant formé par la partie supérieure (20) du moyen de maintien,
le moyen porteur ainsi que le premier élément optique et le second élément optique étant posés dans la partie inférieure,
**caractérisé en ce que**
le moyen porteur (12) est également emprisonné entre la partie inférieure (18) et la partie inférieure (20) du moyen de maintien,
la partie supérieure refermant la partie inférieure et fixant le premier élément optique et le second élément optique sur le moyen porteur.

2. Dispositif optoélectronique (10) selon la revendication 1,
dans lequel l'un desdits au moins trois éléments optiques ou plusieurs desdits au moins trois éléments optiques forment ensemble un canal optique (84) pour ledit au moins un émetteur optoélectronique (40) et/ou pour ledit au moins un récepteur optoélectronique (42).

3. Dispositif optoélectronique (10) selon la revendication 1 ou 2,
dans lequel l'un au moins desdits trois éléments optiques comprend un élément de lentille (16), l'élément de lentille (16) présentant une portion de lentille (68) pour ledit au moins un émetteur optoélectronique (40) et/ou une portion de lentille (68) pour ledit au moins un récepteur optoélectronique (42).

4. Dispositif optoélectronique (10) selon l'une une des revendications précédentes,
dans lequel l'un au moins desdits trois éléments optiques comprend un élément d'ouverture (14, 20), l'élément d'ouverture (14, 20) définissant une plage d'angle d'incidence pour des faisceaux optiques incidents sur ledit au moins un récepteur optoélectronique (42), et/ou définissant une plage d'angle d'émission pour des faisceaux optiques qui sont émis par ledit au moins un émetteur optoélectronique (40).

5. Dispositif optoélectronique (10) selon l'une des revendications 1 à 3,
dans lequel l'un au moins desdits trois éléments optiques comprend un élément d'ouverture (14, 20), l'élément d'ouverture (14, 20) comprenant une portion d'ouverture (52) pour ledit au moins un émetteur optoélectronique (40) et/ou une portion d'ouverture (52) pour ledit au moins un récepteur optoélectronique (42).

6. Dispositif optoélectronique (10) selon la revendication 5,
dans lequel la portion d'ouverture (52) présente une section transversale qui se rétrécit en direction du moyen porteur (12) ; et/ou la portion d'ouverture (52) est formée par un orifice au moins sensiblement tronconique.

7. Dispositif optoélectronique (10) selon l'une des revendications précédentes,
dans lequel l'un au moins desdits trois éléments optiques comprend un élément de filtre (92), l'élément de filtre (92) comprenant une portion de filtre (94) en plan parallèle ayant des propriétés de filtrage spectral.

8. Dispositif optoélectronique (10) selon l'une des revendications précédentes,
dans lequel le premier élément optique comprend un premier élément d'ouverture (14), le second élément optique comprend un élément de lentille (16), et le troisième élément optique comprend un autre élément d'ouverture (20).

9. Dispositif optoélectronique (10) selon l'une des revendications 1 à 7,
dans lequel le premier élément optique comprend un élément de lentille (16), le second élément optique comprend un élément d'ouverture (14), et le troisième élément optique comprend un autre élément de lentille (16).

10. Dispositif optoélectronique (10) selon l'une des revendications 1 à 7,
dans lequel l'un desdits au moins trois éléments optiques comprend un élément de lentille (16), un autre desdits au moins trois éléments optiques comprend un élément d'ouverture (14), et encore un autre desdits au moins trois éléments optiques comprend un élément de filtre (92).

11. Dispositif optoélectronique (10) selon l'une des revendications précédentes,
dans lequel le premier élément optique (14) et/ou le second élément optique (16) sont emprisonnés dans une direction verticale entre le troisième élément optique (20) et le moyen porteur (12).

12. Dispositif optoélectronique (10) selon l'une des revendications précédentes,
dans lequel l'un au moins desdits au moins trois éléments optiques présente au moins un évidement de réception (90) pour recevoir un autre desdits au moins trois éléments optiques.

13. Dispositif optoélectronique (10) selon l'une des revendications précédentes,
dans lequel la partie inférieure (18) et la partie supérieure (20) du moyen de maintien sont fixées l'une à l'autre à l'aide d'un assemblage par enclenchement.

14. Dispositif optoélectronique (10) selon l'une des revendications précédentes,
dans lequel l'un desdits au moins trois éléments optiques comprend une portion de codage mécanique (60) qui fait saillie du moyen de maintien et qui comprend au moins un élément de codage (62, 63) pour identifier le dispositif optoélectronique (10).

15. Système comprenant plusieurs dispositifs optoélectroniques différents (10) selon l'une des revendications précédentes,
dans lequel les premiers éléments optiques desdits plusieurs dispositifs optoélectroniques différents (10) diffèrent les uns des autres par leur conception de forme et/ou les seconds éléments optiques desdits plusieurs dispositifs optoélectroniques différents (10) diffèrent les uns des autres par leur conception de forme et/ou les troisièmes éléments optiques desdits plusieurs dispositifs optoélectroniques différents (10) diffèrent les uns des autres par leur conception de forme.
